(19) **Europäisches Patentamt**

**European Patent Office**

**Office européen des brevets**

(11) **EP 0 608 249 B2**

(12) **NOUVEAU FASCICULE DE BREVET EUROPEEN**

(45) Date de publication et mention de la décision concernant l'opposition:
**12.04.2000 Bulletin 2000/15**

(45) Mention de la délivrance du brevet:
**11.10.1995 Bulletin 1995/41**

(21) Numéro de dépôt: **92918770.6**

(22) Date de dépôt: **28.08.1992**

(51) Int. Cl.$^7$: **H03H 9/64**

(86) Numéro de dépôt international:
**PCT/FR92/00827**

(87) Numéro de publication internationale:
**WO 93/08641 (29.04.1993 Gazette 1993/11)**

(54) **FILTRE A ONDES DE SURFACE ET A TRAJET ACOUSTIQUE REPLIE**

OBERFLÄCHENWELLENFILTER MIT EINEM GEFALTETEN AKUSTISCHEN PFAD

SURFACE WAVE FILTER HAVING A FOLDED ACOUSTIC PATH

(84) Etats contractants désignés:
**CH DE FR GB LI SE**

(30) Priorité: **18.10.1991 FR 9112882**

(43) Date de publication de la demande:
**03.08.1994 Bulletin 1994/31**

(73) Titulaire: **THOMSON-CSF**
**75008 Paris (FR)**

(72) Inventeurs:
• **HODE, Jean-Michel**
**F-92045 Paris-La Défense Cédex 67 (FR)**
• **DESBOIS, Jean**
**F-92045 Paris-La Défense Cédex 67 (FR)**
• **SOLAL, Marc**
**F-92045 Paris-La Défense Cédex 67 (FR)**

(56) Documents cités:
**EP-A- 0 424 240          WO-A-91/09465**
**US-A- 3 946 342          US-A- 4 004 254**
**US-A- 4 144 508**

• **IEEE ULTRASONICS SYMPOSIUM PROCEEDINGS, Denver, Colorado, 14-16 octobre 1987, vol. 1, H.P. FREDRICKSEN et al.: "Differentially detected channelized resonator filter", pages 123-125**

**EP 0 608 249 B2**

**Description**

La présente invention se rapporte à un filtre à ondes acoustiques de surface, ce filtre étant un filtre dont le trajet acoustique a été replié.

Un filtre de ce type comporte généralement, sur un même substrat, au moins un transducteur d'entrée au moins un transducteur de sortie, tous deux bi-directionnels et placés sur ce substrat de manière à définir, pour les ondes acoustiques de surface, un trajet direct longitudinal entre ces deux transducteurs, au moins deux réseaux réfléchissants, ou "réflecteurs": étant par ailleurs respectivement prévus sur ce substrat de part et d'autre de ce couple de transducteurs et sur cet axe longitudinal de propagation des ondes acoustiques de surface, de telle sorte que les centres de transduction des transducteurs se trouvent sur des ventres de la cavité résonnante.

Un filtre de ce type est par exemple connu du document "IEEE Ultrasonics Symposium Proceedings, Denver, Colorado, 14-16 octobre 1987, vol. 1, H.P. Fredricksen et al.: differentially detected channelized resonator filter pages 123-125".

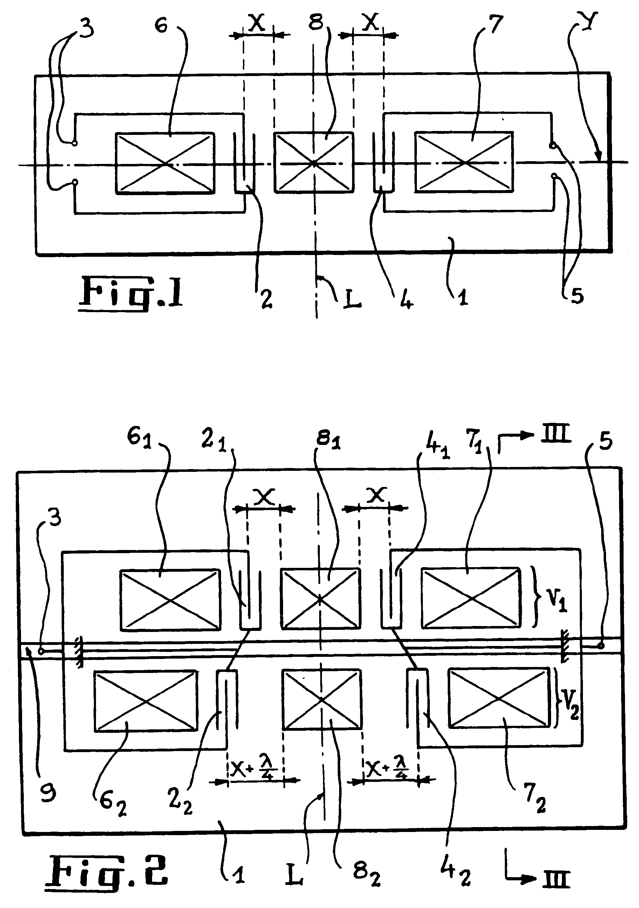

Plus précisément, un filtre "deux pôles" à cavités résonnantes couplées longitudinalement de l'art connu est représenté schématiquement sur la figure 1 jointe.

Ce filtre comporte, sur un même substrat 1 et alignés selon l'axe longitudinal Y de propagation des ondes acoustiques de surface de façon symétrique par rapport à la ligne médiane (L) inter-transducteurs :

. un transducteur d'entrée 2 qui reçoit le signal hyperfréquence appliqué entre les bornes électriques d'entrée 3 du filtre et qui transforme ce signal en ondes acoustiques de surface de même fréquence et se déplaçant, dans un sens comme dans l'autre, sur le substrat 1 et selon la direction longitudinale Y;

. Un transducteur de sortie 4, identique au transducteur 2, et apte inversement à transformer les ondes acoustiques de surface en signaux électriques prélevés sur les bornes électriques de sortie 5 du filtre.

. Deux réseaux réfléchissants "externes" 6 et 7, identiques et placés respectivement, et de façon symétrique, de part et d'autre du couple de transducteurs 2,4 et sur l'axe longitudinal Y de propagation des ondes acoustiques de surface. Ces réseaux sont classiquement formés d'un réseau périodique ou quasi-périodique de réflecteurs élémentaires, la période entre éléments réfléchissants étant un multiple entier de demi-longueurs d'onde à la fréquence centrale de fonctionnement du filtre.

. Un réseau réfléchissant "central" 8 prévu entre les deux transducteurs 2, 4, selon l'axe Y et au milieu de l'intervalle séparant ces deux transducteurs, les distances X entre chacun de ces transducteurs et le bord le plus proche de ce réflecteur central 8 étant égales. Ce réseau 8 est de même périodicité que les réseaux externes 6,7. En revanche, il présente un coefficient de transmission non négligeable, contrairement à ces réseaux externes qui sont en pratique seulement réfléchissants. Ces réseaux réfléchissants (externes et central) peuvent à l'occasion être pondérés pour améliorer leur réponse hors bande (augmentation de la réjection).

En dehors de la "bande d'arrêt" du filtre (c'est-à-dire de la bande de fréquence dans laquelle les réseaux sont réfléchissants), le dispositif se comporte comme un simple ligne à retard, seul le trajet direct entre le transducteur d'entrée 2 et le transducteur de sortie 4 étant pris en compte.

Dans la bande d'arrêt, ce trajet direct existe toujours, mais en outre le dispositif fonctionne selon deux cavités résonnantes couplées longitudinalement :

. une première cavité résonnante définie par les deux réflecteurs 6 et 8,
. une deuxième cavité résonnante définie par les deux réflecteurs 7 et 8.

Le couplage électromécanique avec ces cavités résonnantes est obtenu par les transducteurs d'entrée/sortie 2,4. Suivant la valeur de ce couplage, la surtension des cavités est plus ou moins grande et par suite la bande relative du dispositif plus ou moins faible. De même le couplage entre les deux cavités (c'est-à-dire la transmission du réseau central) doit être adapté à la bande relative à réaliser.

Ainsi, lorsque ce couplage est faible, le nombre de trajets aller-retour entre les réseaux est grand, l'énergie restant longtemps confinée dans les cavités. La réponse impulsionnelle est longue et la bande relative faible le fonctionnement est celui d'un résonateur à fort coefficient de surtension.

Inversement, lorsque ce couplage est fort, une fraction d'énergie importante est absorbée par les transducteurs à chaque passage de l'onde acoustique de surface. La réponse impulsionnelle est alors courte et la bande relative grande : le fonctionnement est celui d'un résonateur à faible coefficient de surtension.

A noter qu'en l'absence de réflecteur central 8, le fonctionnement est celui d'un filtre à une seule cavité résonnante définie par les deux réflecteurs externes 6,7 : on a alors affaire à un filtre "un pôle", alors que le dispositif selon Figure 1 est un filtre "deux pôles", à flancs plus raides. Un tel filtre "un pôle" est connu de WO-A-91/09465

Dans le cas de ce genre de filtre à ondes de surface et à au moins une cavité résonnante, la présence du trajet direct provoque l'apparition de lobes secondaires de niveau d'autant plus élevé que l'on désire élargir la bande passante relative du filtre. La présence de ces lobes secondaires rend ce genre de filtre pratiquement inutilisable pour de larges bandes relatives.

Pour remédier à cet inconvénient l'invention propose un filtre hyperfréquence à ondes acoustiques de surface et à cavités résonnantes longitudinales, tel que défini aux revendications 1 ou 2.

De toute façon, l'invention sera bien comprise, et ses avantages et autres caractéristiques ressortiront, lors de la description suivante de quelques exemples non-limitatifs de réalisation, en référence au dessin schématique annexé, dans lequel :

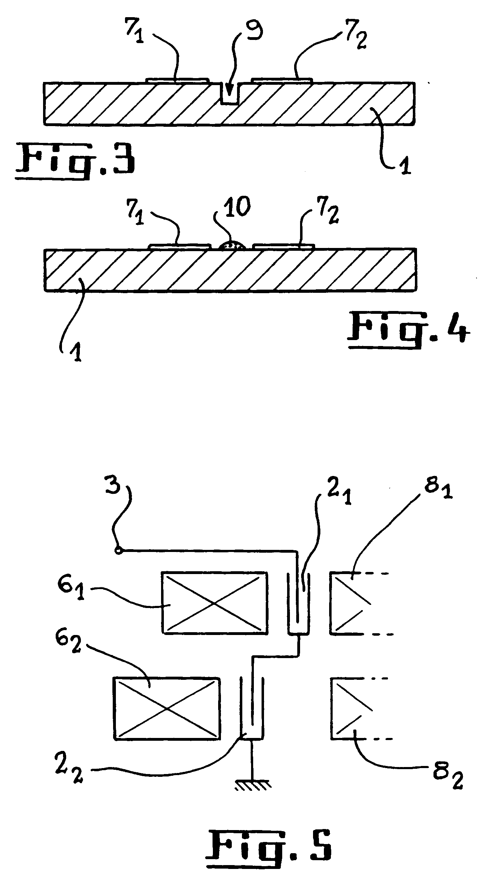

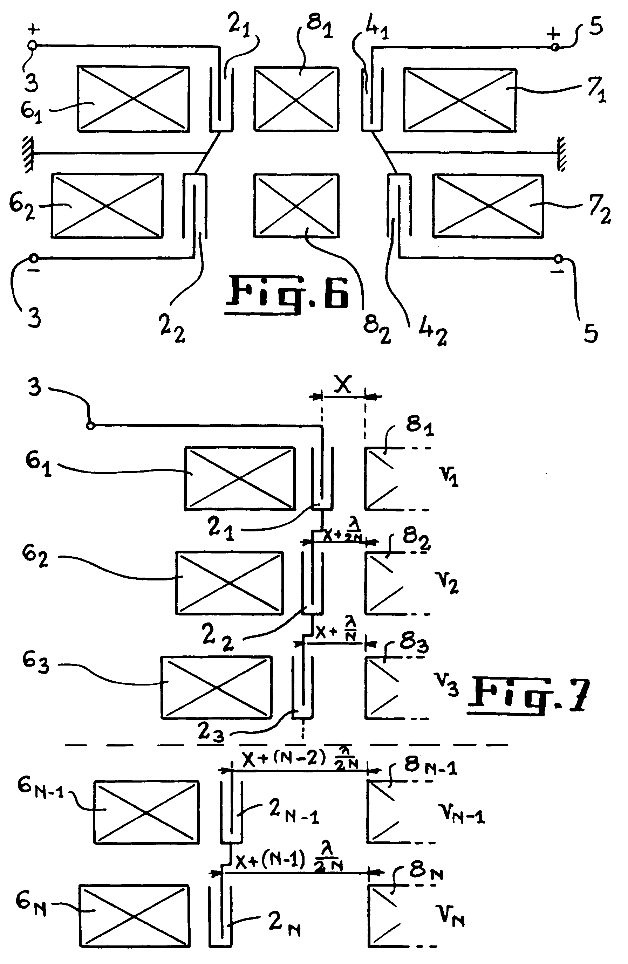

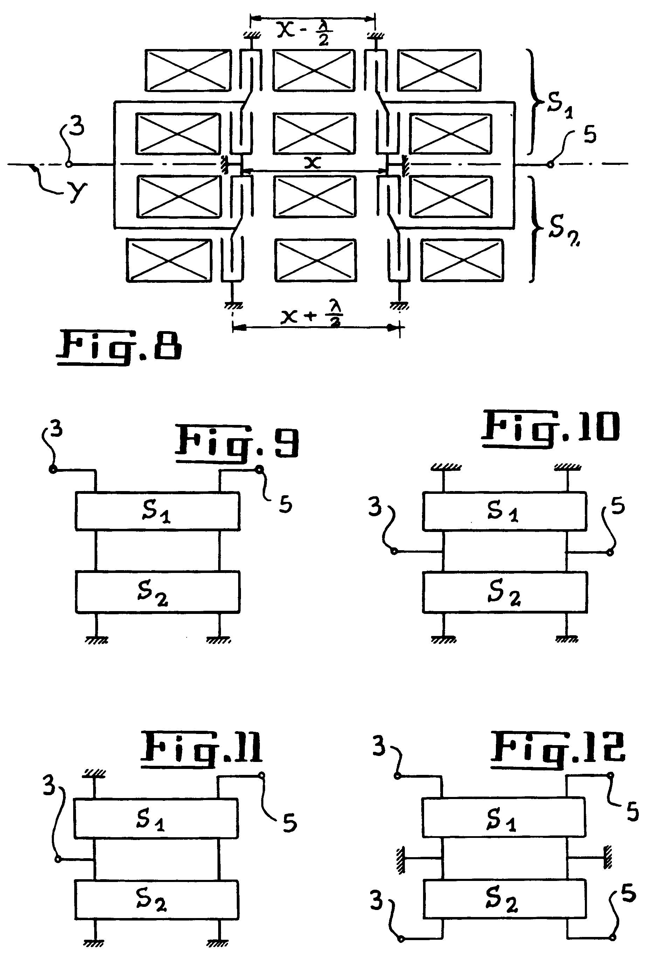

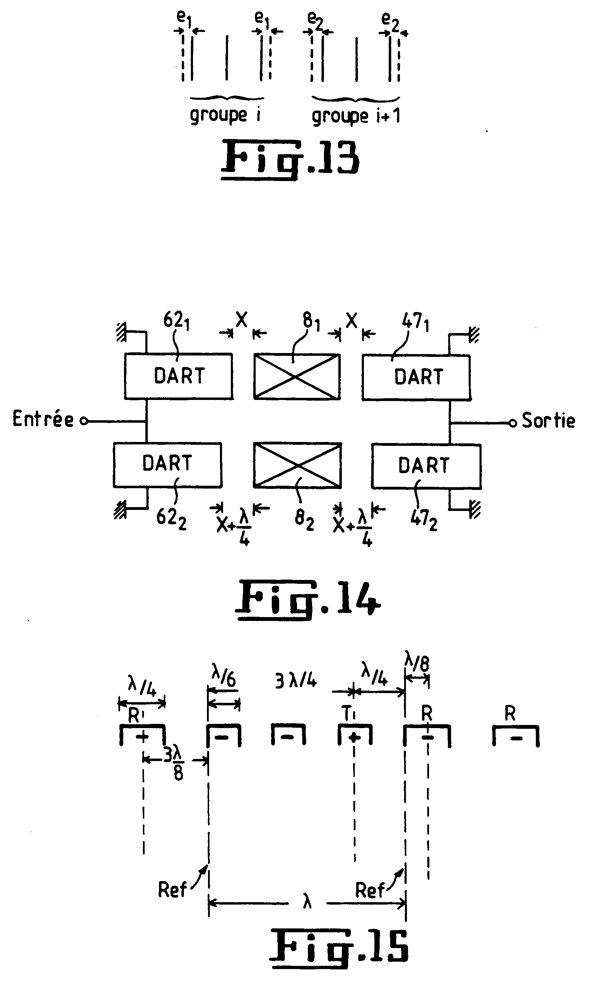

. Figure 2 est une vue en plan d'une première forme de réalisation de ce filtre ;
. Figure 3 est une vue en coupe simplifiée selon III-III de Figure 2 ;
. Figure 4 montre, de façon semblable à Figure 3, une variante de fabrication du filtre selon Figure 2 ;
. Figures 5 et 6 schématisent deux variantes, parmi d'autres, de branchement électrique de ce même filtre ;
. Figure 7 montre, d'une manière généralisée, une structure d'un tel filtre comportant N voies au lieu de deux ;
. Figure 8 montre une variante améliorée du filtre selon Figure 2;
. Figures 9 à 12 sont des synoptiques de montages possibles pour ce genre de variante améliorée.
. Figure 13 montre une variante de pondération des cellules réflectrices ;
. Figure 14 montre une variante de l'invention où les transducteurs et les réflecteurs extérieurs sont réunis pour former des "DART" ; et
. Figures 15 à 18 montrent des variantes des cellules élémentaires des DART de la figure 14.

En se reportant aux figures 2 et 3, il s'agit d'un filtre à ondes acoustiques de même type que celui selon Figure 1, mais comportant deux voies en parallèle entre les bornes d'entrée/sortie 3,5 :

. une première voie V1 constituée en soi d'un filtre similaire à celui selon Figure 1, et comportant de ce fait un réflecteur central $8_1$ placé à égales distances X du transducteur d'entrée $2_1$ et du transducteur de sortie $4_1$, et deux réflecteurs externes $6_1$ et $7_1$ placés symétriquement et de part et d'autre de ces deux transducteurs ; et
. une deuxième voie V2 qui, avec ses transducteurs d'entrée/sortie $2_2$, $4_2$, son réflecteur central $8_2$, et ses réflecteurs externes $6_2$, $7_2$, est pratiquement identique à la voie V1, à la différence essentielle près que, conformément à l'invention, les distances séparant les transducteurs $2_2$ et $4_2$ du bord le plus proche du réflecteur central 82 ne sont ici pas égales à X, mais égales à $X + \lambda / 4$, où $\lambda$ est la longueur d'onde correspondant à la fréquence centrale du signal électrique.

Tous les éléments actifs et passifs des voies V1 et V2 étant identiques, les amplitudes de transmission de ces deux voies sont les mêmes. Il en résulte que, compte-tenu de la différence de trajets directs $2_1$ - $4_2$ et $2_2$ - $4_2$ entre les deux voies V1 et V2 qui est égale à $\lambda / 2$, la résultante vectorielle des signaux prélevés sur les transducteurs de sortie $4_1$, $4_2$ et correspondant au trajet direct est nulle. Il y a donc pratiquement, dans la courbe de réponse de ce filtre, annulation de la fonction de transfert en ligne à retard en dehors de la bande d'arrêt du filtre, ce résultat étant bienentendu, comme on y viendra ci-après, seulement rigoureux pour la fréquence centrale du filtre.

En revanche, les trajets réfléchis multiples pour lesquels il existe entre les deux voies V1, V2 des différences égales à un multiple pair de demi-longueurs d'onde se retrouvent en sortie tous en phase, ou trajets d'ordre pair, et ne sont donc pas affectés par ce décalage entre voies.

A noter que si les éléments du filtre étaient tous purement et simplement placés sur un seul substrat tel que celui selon Figure 1, il apparaitrait des couplages parasites entre les voies dus aux ondes de surface non rigoureusement longitudinales et allant de ce fait d'une voie vers l'autre.

Conformément à un aspect avantageux de l'invention, cet inconvénient est évité, sans qu'il soit nécessaire de prévoir un substrat distinct pour chacune des voies V1 et V2, par le fait qu'une gorge longitudinale, ou rainure, 9 est creusée longitudinalement dans le substrat unique 1, de manière à séparer physiquement et en surface des voies V1 et V2. Les ondes de surface ne se propagent alors pratiquement pas d'une voie vers l'autre, en revanche les connexions électriques entre voies peuvent par exemple être réalisées sans problèmes par technique de connexion filaire par dessus cette rainure 9.

En variante, comme représenté en Figure 4, il est possible, au lieu de creuser cette gorge 9, de déposer à la même place une couche longitudinale 10 en matériau absorbant pour les ondes acoustiques de surface, de tels matériaux étant sans problèmes disponibles dans le commerce.

Pour éviter le couplage acoustique entre ces voies V1 et V2, il est aussi possible de décaler ces voies longitudinalement l'une par rapport à l'autre, en choisissant ce décalage pour que les deux trajets croisés "V1 vers V2" et "V2 vers V1" soient en opposition de phase. Ce décalage dépend de l'ouverture acoustique des voies ainsi que de leur séparation.

A noter que dans cet exemple, les transducteurs d'entrée $2_1$, $2_2$ d'une part, et les transducteurs de sortie $4_1$, $4_2$ d'autre part, sont connectés électriquement en parallèle. Leurs admittances s'ajoutent , ce qui diminue l'impédance de sortie : une telle configuration est bien adaptée aux sorties à basse impédance.

Il va de soi que ce mode de connexion est optionnel, et que toutes les autres configurations sont réalisables du point de vue électrique sans changer le résultat dû à l'invention: configuration série-série (entrées et sorties respectivement), parallèle-série, série-parallèle, montages différentiels à point milieu relié ou non à la masse, etc...

La figure 5 montre par exemple, pour ce filtre selon Figure 2, une configuration série des transducteurs d'entrée $2_1$, $2_2$. La même configuration étant utilisée pour les transducteurs de sortie (non-représentés), ce sont cette fois ci les impédances qui s'ajoutent, augmentant par suite l'impédance de sortie du filtre : cette configuration est adaptée aux sorties à haute impédance.

Un autre exemple de connexion est donné sur la figure 6, où il s'agit de branchement en montage différentiel, un tel montage étant adapté à ce type d'électronique où les circuits sont alimentés de manière symétrique par rapport à la masse ; etc...

Il va de soi que la structure à deux voies selon la Figure 2 n'est que préférentielle, et peut souffrir des modifications sans sortir du cadre de l'invention. C'est ainsi que la différence de trajets directs peut être égale à $\lambda / 2 + p\lambda$ , p étant un nombre entier, ce qui bien entendu ne change rien en ce qui concerne l'annulation de la fonction de transfert en ligne à retard, c'est-à-dire en trajet direct hors bande d'arrêt. Le caractère symétrique de chaque voie par rapport au réflecteur central est préférentiel, mais pas forcément obligatoire. Les réflecteurs peuvent être différents pour chacune de ces deux voies, pour peu que la condition d'identité des amplitudes de transmission soit respectée.

En supposant les réseaux réfléchissants centraux $8_1$, $8_2$ symétriques et sans pertes, les coefficients de réflexion r et de transmission t sont de la forme :

$$r = j \sin \Delta . e^{-j\phi}$$

$$t = \cos\Delta . e^{-j\phi}$$

Si R est le coefficient de réflexion des réseaux externes, la fonction de transfert du filtre est de la forme : R. $\sin 2\Delta$.

Pour minimiser les pertes, il faut avantageusement avoir un angle $\Delta$ égal à $\Pi / 4$, auquel cas les modules de r et de t sont égaux à $1/ \sqrt{2}$ à la fréquence centrale. De plus, les circuits d'adaptation adaptent, à cette fréquence, les impédances de source et de charge à l'impédance que présenteraient les couples de transducteurs avec leurs réseaux externes associés.

A noter qu'il est toutefois possible d'accepter une dégradation du point de vue des pertes d'insertion pour agir sur la largeur de la bande.

Le coefficient de réflexion du réflecteur central devrait être proche de -3dB, ce qui correspond à autant d'énergie réfléchie que d'énergie transmise. En outre, pour améliorer la réjection (niveau hors de la bande), on peut pondérer le réflecteur central. De manière connue, cette pondération sera par exemple obtenue par suppression de sources (les sources étant les réflecteurs) et on ajustera le nombre de réflecteurs pour avoir un coefficient de réflexion proche de -3dB. Suivant le nombre de sources supprimées, le réseau se trouve plus ou moins "sous-échantillonné", c'est-à-dire qu'il y a des espaces libres entre les réflecteurs.

Pour garder un taux de métallisation constant, utile en raison des variations de la température de turn-over dues à la métallisation, on remplira ces espaces libres avec des cellules non réflectrices comptant par exemple 2 électrodes avec une période $\lambda/4$, ou bien 3 électrodes avec une période $\lambda/3$.

Suivant une variante la pondération peut également être obtenu en formant des groupes de réflecteurs que l'on décale légèrement pour pondérer le coefficient de réflexion propre à chaque groupe comme représenté sur la figure 13 pour un groupe i avec un décalage $e_1$ et un groupe i + 1 avec un décalage $e_2$.

L'exemple de réalisation qui vient d'être décrit s'applique à un filtre comportant deux voies V1 et V2 en parallèle.

L'invention s'applique néanmoins tout aussi bien pour un nombre N de voies supérieur à deux, comme schématisé (pour un seul côté) sur la figure 7.

La différence de trajet direct entre les deux voies consécutives est alors, dans un tel cas, égale à $\lambda/N$ à bien entendu un nombre entier de longueurs d'ondes $\lambda$ près, de sorte que la résultante vectorielle de tous les trajets directs des voies V1 à VN est nulle.

Avec la disposition symétrique, semblable à celle selon Figures 2 et plus précisément 5, adoptée pour la figure 7, les distances entre transducteur d'entrée 2 et réflecteur central 8 sont de :

X pour la voie V1

X + $\lambda/2N$ pour la voie V2

X + $\lambda/N$ pour la voie V3

X + (N-2) . λ/2N pour la voie VN-1

et X+ (N-1) . λ/2N pour la voie VN.

La fonction de transfert du filtre est égale à la somme de toutes les contributions. Dans le cas de N voies symétriques (notées de 1 à N) et décalées de

$$X + \frac{2n - (N + 1)}{2N} (kN + 1),$$

elle est de la forme :

$$\sum_{n=1}^{N} F_n \left[ (kN + 1) \, n\pi \, f \, / \, fo \right] R^{n-1} e^{(-j\pi\phi)} \begin{Bmatrix} \cos n\Delta \\ j \sin n\Delta \end{Bmatrix} \begin{array}{l} \dots n \text{ impair} \\ Tea_1 . Tea_2 \\ \dots n \text{ pair} \end{array}$$

où R est le coefficient de réflexion des réseaux $\phi$, la phase correspondant à la distance inter-transducteurs moyenne et $Tea_1$ et $Tea_2$ les fonctions de transfert électro-acoustiques de l'ensemble constitué des transducteurs d'entrée et de sortie et des réseaux réfléchissants arrière. Par le jeu des différences de phase entre voies, les fonctions de filtrage Fn sont toutes nulles à la fréquence centrale à l'exception de FN. On voit ainsi comment l'ensemble des réflecteurs participe directement à la fonction de transfert.

Près de la fréquence centrale du filtre, la fonction de transfert du filtre est de la forme :

- pour N pair : $R^{N-1} \sin (N\Delta)$
- pour N impair : $R^{N-1} \cos (N\Delta)$

Pour la réjection hors bande, N pair est préférable pour bénéficier d'un surcroît de réjection dû à la réponse du réflecteur central, car $\Delta$ tend vers 0 hors de la bande passante.

La valeur optimale du coefficient de réflexion du réflecteur central à la fréquence de la bande passante est $|r| = \sin (\Pi/2N)$ pour N pair. Lorsque N est impair $\Delta = 0$ est une première solution. Cette solution correspond à l'absence de réflecteur central et n'est donc pas conforme à l'invention telle que définie dans les revendications. L'autre solution optimale est $|r| = \sin (\Pi/2N)$.

On peut néanmoins s'écarter de ces solutions pour ladite valeur du coefficient de réflexion dans le but de jouer sur la forme et la largeur de la bande passante, pour au qu'un réflecteur central soit présent.

Près de la fréquence centrale fo du filtre, la fonction de transfert du filtre est de la forme: $R^{N-1} \cdot \sin (N_D)$ (pour N pair). La seule contribution non nulle à la fréquence centrale est le dernier terme lié au Nième trajet (c'est le principe de la structure) Les fonctions de filtrage Fn traduisent la mise en parallèle des N voies. Elles sont toutes, sauf FN, nulles à la fréquence centrale mais présentent une bande finie, d'autant plus faible que (kN+1) est grand. Le cas le plus favorable est donc obtenu pour k = 0. Etant donné que la fonction de transfert tend vers 0 en dehors de la bande passante les contributions gênantes par l'intermédiaire de cet effet sont celles des trajets d'ordre impair (donnant lieu à des cosinus) et plus particulièrement le trajet direct qui n'est pas du tout filtré par des réflecteurs arrière.

Pour fixer les idées, la réjection du fonctionnement en direct est, pour le cas particulier N = 2 (2 voies) et dans le cas le plus favorable k = 0 :

- totale pour f = fo
- 36 dB pour f = (1 ± 1 %) fo
- 22 dB pour f = (1 ± 5 %) fo
- 10 dB pour f = (1 ± 20 %) fo

Afin de remédier à cet inconvénient, et donc d'améliorer encore la réjection en trajet direct, une variante de la présente invention consiste à mettre en parallèle deux structures à voies multiples selon Figure 2, et plus généralement selon Figure 7, ces structures étant du même type, mais les décalages des trajets directs variant en sens inverses d'une structure à l'autre par rapport à l'axe longitudinal Y de symétrie de l'ensemble et au fur et a mesure que l'on s'éloigne de ce dernier, bien que les décalages relatifs entre voies soient égaux en valeurs absolues pour chacune de ces deux structures.

En d'autres termes, cette variante revient à réaliser un filtre en utilisant deux structures précédentes, chacune à N voies, de manière à apporter une réjection supplémentaire sur tous les trajets d'ordre impair, tout en n'affectant nullement les autres trajets. Pour cela il est nécessaire que les distances inter-transducteurs des N voies des deux structures suivent les progressions arithmétiques suivantes, permettant d'apporter un déphasage entre structures égal à un multiple pair de λ pour les trajets d'ordre pair et égal à un multiple impair de λ pour les trajets d'ordre impair (dont le trajet direct) :

$$
\begin{cases}
X + \dfrac{2n - (N + 1)}{2N} \ (kN + 1) \ \lambda + (2M + 1) \ \lambda \ / \ 4 \ \text{pour la 1ère structure} \\
X - \dfrac{2n + (N + 1)}{2N} \ (kN + 1) \ \lambda + (2M + 1) \ \lambda \ / \ 4 \ \text{pour la 2ème structure}
\end{cases}
$$

La nouvelle forme de la fonction de transfert est alors approximativement la suivante :

$$
\sum_{n=1}^{N} F_n \left[ (kN + 1) \ n\pi f \ / \ fo \right] \ e^{-jn\ast} \begin{Bmatrix} \cos n\Delta \\ j \sin n\Delta \end{Bmatrix} \begin{matrix} \cdots \ n \ \text{impair} \\ \ \\ \cdots \ n \ \text{pair} \end{matrix} \ T_1 \ T_2 R^{n-1} \ \cos \left[ \dfrac{n\pi}{2} \ (2M + 1) \ f \ / \ fo \right]
$$

forme sur laquelle on constate effectivement le filtrage supplémentaire opéré sur les trajets d'ordre impair par l'intermédiaire du dernier terme en cosinus.

En reprenant le cas précédent (N = 2 et k = 0), on trouve aisément que la réjection du trajet direct exprimé en dB est doublée :

- totale pour f = fo
- 72 dB pour f = (1 ± 1 % ) fo
- 44 dB pour f = (1 ± 5 %) fo
- 20 dB pour f = (1 ± 20 %) fo

Un exemple simple de réalisation appliqué à ce dernier cas est représenté en Figure 8. Il s'agit en l'espèce d'un filtre réalisant la mise en parallèle de deux structures S1, S2 toutes deux semblables à la structure selon Figure 2, mais où les distances inter-transducteurs sont :

X - λ/2  et X pour la structure S1; et

X et X + λ/2  pour la structure S2, ce qui donne une différence de λ/2 pour tous les trajets directs de même rang.

De même que pour les voies elles-mêmes, il est bien évident que tous les types de connexions électriques entre les deux structures S1 et S2 sont envisageables et, à ce sujet, les figures 9 à 12 montrent respectivement quatre types de connexions possibles : série-série, parallèle-parallèle, parallèle-série, et montage différentiel (dans cette dernière variante, la connexion du point milieu à la masse n'est pas obligatoire).

Les structures précédentes conviennent bien lorsque l'on désire obtenir des pertes d'insertion faibles car elles fonctionnent "en résonance". Ces pertes sont typiquement de l'ordre de -3dB et pour cela il faut que le nombre de traits réflecteurs des réseaux extérieurs soit le plus grand possible.

La sensibilité d'un transducteur aux éléments qui permettent de réaliser l'accord électrique est d'autant plus grande que son coefficient de qualité est fort. On rappelle que le coefficient de qualité est défini comme le rapport de la susceptance du transducteur à sa conductance. Ce coefficient vaut $k^2/M$, où $k^2$ est le coefficient de couplage piézo-électrique du matériau et M le nombre d'électrodes actives du transducteur. Comme on souhaite diminuer cette sensibilité, pour un matériau donné on est amené à augmenter M.

De plus on a toujours intérêt à diminuer la longueur du composant pour des questions d'encombrement et de coût.

Toutes ces considérations amènent à imbriquer les réflecteurs des réseaux extérieurs dans les transducteurs pour constituer des transducteurs connus sous le nom de "DART" (abréviation de Distributed Acoustic Reflection Transducer). En effet de cette manière, pour une longueur donnée, on a un maximum de traits réflecteurs d'une part et d'électrodes actives d'autre part.

On obtient donc la structure générale représentée en figure 14 comportant deux réflecteurs centraux $8_1$ et $8_2$ et quatre transducteurs/réflecteurs du type DART.$62_1$, $62_2$, $47_1$ et $47_2$. Ceci s'applique à toutes les variantes, en particulier celles des figures 9 à 12 qui seront décrites plus loin.

Une structure DART est connue du brevet français N° 2 653 632 déposé par la Demanderesse le 20 octobre 1989. La version la plus simple de la cellule de base de cette structure est représentée sur la figure 15. Cette version comprend une cellule émettrice comportant 3 électrodes et une cellule réflective comportant 2 électrodes.

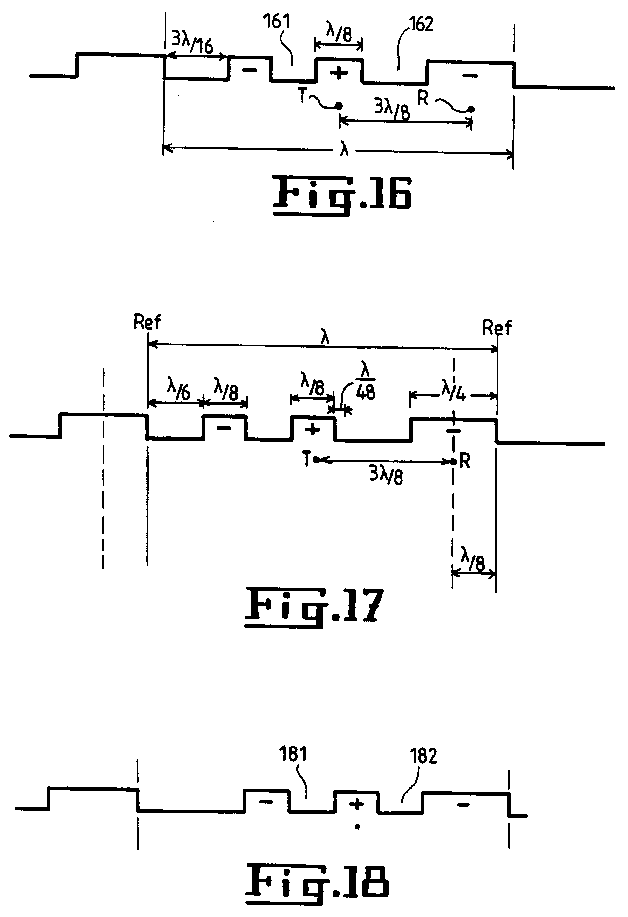

Une autre structure de DART, connue sous le nom EWC (abréviation de Electrode Width Control), est formée de cellules de longueur 1 $\lambda$, comportant chacune un réflecteur et une source, comme représenté sur la figure 16.

Cette structure présente par rapport à la structure précédente les avantages de ne pas générer de sous-harmoniques et de permettre un meilleur compromis réflexion-transduction.

La figure 16 constitue la cellule de base où les centres de transduction T et de réflexion R sont placés respectivement au centre de l'électrode + et au centre du réflecteur. En fait cette structure n'est pas optimale, car l'électrode + étant entourée de 2 espaces inter-électrodes différents 161 et 162, son centre de transduction n'est pas exactement au centre de cette électrode. Pour pallier cet inconvénient, une autre structure consiste à décaler la source (c'est-à-dire les 2 électrodes à $\lambda/8$ d'une distance $\Delta x$ de la position à 3 $\lambda/8$. Ainsi les réflexions sur les 2 électrodes de largeur $\lambda/8$) continuent d'être en opposition de phase et un choix approprié de $\Delta x$ permet de placer le centre de transduction au point optimal (à $3\lambda/8$ du réflecteur). Pour le quartz, l'expérience montre que la valeur $\Delta x$ pour obtenir ce résultat est proche de $+\lambda/48$ comme représenté en figure 17. Suivant une variante représentée en figure 18, on utilise un décalage $\Delta x = -\lambda/16$ ce qui permet de rendre égaux les 2 espaces inter-électrodes 181 et 182 et facilite la synthèse du filtre. Toutefois alors la distance optimale $3\lambda/8$ n'est plus respectée, ce qui entraîne des ondulations plus importantes que précédemment mais qui pour certaines applications peuvent être acceptées.

La structure des 2 DART est telle que les coefficients de réflexion en court-circuit sont égaux. Toutefois, cette condition n'impose pas une identité complète de ces 2 DART. Ainsi les transductions peuvent être différentes. Si l'on veut notamment obtenir une meilleure réjection par un filtrage supplémentaire du trajet direct l'un des DART (ou les deux) peut être pondéré par suppression de sources (les sources étant les électrodes actives), ou bien par recouvrement variable des doigts. On préférera ce dernier moyen, sur un DART seulement, lorsque l'on veut obtenir une bonne réjection lointaine.

L'invention peut également être étendue, en remplaçant l'ensemble "transducteur-réflecteur externe" par tout dispositif directif (totalement ou partiellement unidirectionnel) tel que transducteur "3 phases" ou à groupe, transducteur bi-directionnel placé à l'intérieur d'un coupleur multiplitraits 3dB replié; etc...

Ces structures permettent d'obtenir une atténuation plus grande des signaux parasites dus aux ondes de volume. En effet les ondes de volume étant peu affectées par les métallisations (ou gravures) en surface sont peu réfléchies par le réflecteur central. Donc seul le trajet direct intervient pour ces ondes et comme la structure permet d'éliminer ce trajet, les ondes de volume sont fortement réduites. Expérimentalement, on a constaté qu'il n'était pas nécessaire de traiter (généralement par sablage) la face arrière du substrat pour obtenir des filtres à réjection de l'ordre de -60 dB. Des réjections très fortes alors peuvent être envisagées avec un tel traitement.

## Revendications

1. Filtre à ondes acoustiques de surface et à cavités résonnantes longitudinales ($6_1$, $8_1$ ; $7_1$ ; $6_2$, $8_2$ ; $8_2$, $7_2$), composé d'un nombre entier N, au moins égal à 2, de voies parallèles de filtrage (V1, V2, ...) comportant chacune un transducteur d'entrée ($2_1$, $2_2$, ...) et un transducteur de sortie ($4_1$, $4_2$, ..) définissant entre eux deux un trajet direct, et au moins deux réseaux réfléchissants ($6_1$ ; $7_1$,), définissant pour cette voie au moins une cavité résonnante longitudinale, les amplitudes de transmission étant, au moins pour ces trajets directs, pratiquement les mêmes pour ces N voies, caractérisé en ce que :

   - N est un nombre pair supérieur ou égal à 2 ;
   - la différence de longueur de propagation en trajet direct est, pour deux voies consécutives (V1, V2), sensiblement égale, à un nombre entier de longueurs d'onde ($\lambda$) à la fréquence centrale de filtrage (fo) près, au Nième de cette longueur d'onde ($\lambda$), de sorte que pour cette fréquence centrale (fo), la résultante vectorielle des signaux de ces N voies qui correspondent aux trajets directs est pratiquement nulle ;
   - et en ce que chaque voie comprend un réflecteur central ($8_1$, $8_2$) ;

   et qu'en conséquence il y a pratiquement annulation de la fonction de transfert en ligne à retard en dehors de la bande d'arrêt du filtre.

2. Filtre à ondes acoustiques de surface et à cavités résonnantes longitudinales ($6_1$, $8_1$ ; $7_1$ ; $6_2$, $8_2$ ; $8_2$ , $7_2$), composé d'un nombre entier N, au moins égal à 2, de voies parallèles de filtrage (V1, V2, ...) comportant chacune un transducteur d'entrée ($2_1$, $2_2$, ...) et un transducteur de sortie ($4_1$, $4_2$, ..) définissant entre eux deux un trajet direct, et au moins deux réseaux réfléchissants ($6_1$ ; $7_1$,), définissant pour cette voie au moins une cavité résonnante longitudinale, les amplitudes de transmission étant, au moins pour ces trajets directs, pratiquement les mêmes pour ces N voies, caractérisé en ce que :

- N est un nombre impair supérieur ou égal à 3 ;
- la différence de longueur de propagation en trajet direct est, pour deux voies consécutives (V1, V2), sensiblement égale, à un nombre entier de longueurs d'onde ($\lambda$) à la fréquence centrale de filtrage (fo) près, au Nième de cette longueur d'onde ($\lambda$), de sorte que pour cette fréquence centrale (fo), la résultante vectorielle des signaux de ces N voies qui correspondent aux trajets directs est pratiquement nulle ;

et qu'en conséquence ii y a pratiquement annulation de la fonction de transfert en ligne à retard en dehors de la bande d'arrêt du filtre.

3. Filtre selon l'une des revendications 1 ou 2, caractérisé en ce que chaque couple formé par un transducteur et un réseau réfléchissant extérieur forme un seul dispositif du type DART ($62_1$ - $47_2$).

4. Filtre selon l'une des revendications 1 à 3, caractérisé en ce que les coefficients de réflexion en court-circuit des dispositifs DART ($62_1$-$47_2$) sont égaux.

5. Filtre selon l'une quelconque des revendications 3 et 4, caractérisé en ce que l'un au moins des dispositifs DART ($62_1$- $47_2$) est pondéré par suppression de sources.

6. Filtre selon l'une quelconque des revendications 3 et 4, caractérisé en ce que l'un au moins des dispositifs DART ($62_1$- $47_2$) est pondéré par recouvrement variable des doigts.

7. Filtre selon l'une quelconque des revendications 3 à 6, caractérisé en ce que l'un au moins des dispositifs DART ($62_1$ - $47_2$) est du type EWC avec un décalage de $\lambda/48$.

8. Filtre selon l'une quelconque des revendications 3 à 6, caractérisé en ce que l'un au moins des dispositifs DART ($62_1$- $47_2$) est du type EWC avec un décalage de - $\lambda/16$.

9. Filtre selon l'une quelconque des revendications 3 à 6, caractérisé en ce que l'un au moins des dispositifs DART ($62_1$- $47_2$) est formé d'un ensemble de cellules émettrices et de cellules réflectrices alternées, chaque cellule émettrice comportant trois électrodes de largeur $\lambda/6$ espacées de $3\lambda/4$ sur une distance égale à $\lambda$ avec deux électrodes inactives suivie d'une électrode active, et chaque cellule réflectrice comportant deux électrodes inactives de largeur $\lambda/4$ espacées de $3\lambda/8$ sur une distance égale à $\lambda$.

10. Filtre à ondes de surface selon l'une quelconque des revendications 1 à 9, caractérisé en ce qu'il est placé sur un substrat unique (1), et en ce qu'une rainure longitudinale (9) est creusée dans ce substrat entre chacune desdites voies (V1, V2...) afin de les isoler l'une de l'autre pour les ondes acoustiques de surface.

11. Filtre à ondes de surface selon l'une quelconque des revendications 1 à 9, caractérisé en ce qu'il est placé sur un substrat unique (1) et en ce qu'une couche longitudinale (10) en matériau absorbant pour les ondes acoustiques de surface est déposée entre chacune desdites voies (V1, V2,...).

12. Filtre à ondes de surface selon l'une quelconque des revendications 1 a 11, caractérisé en ce que chacune de ces voies (V1, V2, ...) est symétrique par rapport à la ligne médiane (L) de l'espace intertransducteurs.

13. Filtre à ondes de surface selon la revendication 1, caractérisé en ce que chacune de ces voies comporte un réflecteur central (8) et deux réflecteurs externes (6,7).

14. Filtre à ondes de surface selon l'une des revendications 1 à 13, caractérisé en ce que, afin d'assurer une réjection supplémentaire en trajet direct pour les fréquences qui, dans la bande d'arrêt, s'écartent de ladite fréquence centrale (fo), ii est constitué par la mise en parallèle de deux de ces structures multivoies (S1, S2) précitées, ces structures étant du même type, mais les décalages des trajets directs (X-$\lambda/2$ , X+$\lambda/2$ ) variant en sens inverses d'une structure (S1) à l'autre (S2) par rapport à l'axe longitudinal de symétrie (Y) de l'ensemble et au fur et à mesure que l'on s'éloigne de ce dernier.

15. Filtre selon l'une quelconque des revendications 1 à 13, caractérisé en ce que le nombre d'électrodes du réflecteur central (81, 82) est choisi pour que le coefficient de réflexion soit sensiblement égal à -3 dB.

16. Filtre selon la revendication 15, caractérisé en ce que le réflecteur central (81, 82) est en outre pondéré par suppression d'électrodes et qu'il comporte des cellules neutres qui remplacent les électrodes supprimées pour maintenir un taux de métallisation constant.

17. Filtre à ondes de surface selon l'une quelconque des revendications 1 à 16, caractérisé en ce qu'il est placé sur un substrat unique (1) et en ce que lesdites voies (V1, V2, ...) sont décalées longitudinalement l'une par rapport à l'autre de façon à annuler, par mise en opposition de phase, les couplages entre ces voies.

18. Filtre selon l'une quelconque des revendications 1 à 17, caractérisé en ce qu'il ne comprend aucun traitement contre les ondes de volume du substrat sur lequel sont implantés les organes du filtre.

**Claims**

1. Surface acoustic wave filter with longitudinal resonant cavities ($6_1$, $8_1$ ; $7_1$ ; $6_2$, $8_2$ ; $8_2$, $7_2$), composed of an integer number N, equal to at least 2, of parallel filtering channels (V1, V2, ...) each including an input transducer ($2_1$, $2_2$, ...) and an output transducer ($4_1$, $4_2$, ...) defining a direct path between the two of them, and at least two reflecting gratings ($6_1$ ; $7_1$,), defining for this channel at least one longitudinal resonant cavity, the transmission amplitudes being, at least for these direct paths, practically the same for these N channels, characterized in that:

   - N is an even number greater than or equal to 2;
   - the difference in propagation length in the direct path is, for two consecutive channels (V1, V2), substantially equal, to within an integer number of wavelengths ($\lambda$) at the central filtering frequency (fo), to one Nth of this wavelength ($\lambda$), so that for this central frequency (fo), the vector resultant of the signals of these N channels which correspond to the direct paths is practically zero;
   - and in that each channel comprises a central reflector ($8_1$, $8_2$);

   and that in consequence there is practically cancellation of the delay line transfer function outside the stop band of the filter.

2. Surface acoustic wave filter with longitudinal resonant cavities ($6_1$, $8_1$ ; $7_1$ ; $6_2$, $8_2$ ; $8_2$, $7_2$), composed of an integer number N, equal to at least 2, of parallel filtering channels (V1, V2, ...) each including an input transducer ($2_1$, $2_2$, ...) and an output transducer ($4_1$, $4_2$, ...) defining a direct path between the two of them, and at least two reflecting gratings ($6_1$ ; $7_1$,), defining for this channel at least one longitudinal resonant cavity, the transmission amplitudes being, at least for these direct paths, practically the same for these N channels, characterized in that:

   - N is an odd number greater than or equal to 3;
   - the difference in propagation length in the direct path is, for two consecutive channels (V1, V2), substantially equal, to within an integer number of wavelengths ($\lambda$) at the central filtering frequency (fo), to one Nth of this wavelength ($\lambda$), so that for this central frequency (fo), the vector resultant of the signals of these N channels which correspond to the direct paths is practically zero;

   and that in consequence there is practically cancellation of the delay line transfer function outside the stop band of the filter.

3. Filter according to either of Claims 1 and 2, characterized in that each pair formed by a transducer and an outer reflecting grating forms a single device of the DART type ($62_1$ - $47_2$).

4. Filter according to one of Claims 1 to 3, characterized in that the short-circuit reflection coefficients of the DART devices ($62_1$ - $47_2$) are equal.

5. Filter according to either one of Claims 3 and 4, characterized in that one at least of the DART devices ($62_1$ - $47_2$) is weighted by source suppression.

6. Filter according to either one of Claims 3 and 4, characterized in that one at least of the DART devices ($62_1$ - $47_2$) is weighted by variable overlap of the fingers.

7. Filter according to any one of Claims 3 to 6, characterized in that one at least of the DART devices ($62_1$ - $47_2$) is of the EWC type with a $\lambda/48$ offset.

8. Filter according to any one of Claims 3 to 6, characterized in that one at least of the DART devices ($62_1$ - $47_2$) is of the EWC type with a - $\lambda/16$ offset.

9. Filter according to any one of Claims 3 to 6, characterized in that one at least of the DART devices ($62_1$ - $47_2$) is formed by a set of alternating transmitting cells and reflecting cells, each transmitting cell including three electrodes of width $\lambda/6$ spaced $3\lambda/4$ apart over a distance equal to $\lambda$ with two inactive electrodes followed by an active electrode, and each reflecting cell including two inactive electrodes of width $\lambda/4$ spaced $3\lambda/8$ apart over a distance equal to $\lambda$.

10. Surface wave filter according to any one of Claims 1 to 9, characterized in that it is placed on a single substrate (1), and in that a longitudinal groove (9) is gouged into this substrate between each of the said channels (V1, V2 ...) so as to isolate them from one another in respect of the surface acoustic waves.

11. Surface wave filter according to any one of Claims 1 to 9, characterized in that it is placed on a single substrate (1) and in that a longitudinal layer (10) of a material absorbent in respect of the surface acoustic waves is deposited between each of the said channels (V1, V2, ...).

12. Surface wave filter according to any one of Claims 1 to 11, characterized in that each of these channels (V1, V2, ...) is symmetric with respect to the mid-line (L) of the inter-transducer gap.

13. Surface wave filter according to Claim 1, characterized in that each of these channels includes a central reflector (8) and two outer reflectors (6, 7).

14. Surface wave filter according to one of Claims 1 to 13, characterized in that, so as to ensure further rejection in the direct path for the frequencies which, in the stop band, are distant from the said central frequency (fo), it is constituted by the placing in parallel of two of these aforesaid multichannel structures (S1, S2), these structures being of the same type, but the offsets of the direct paths ($X-\lambda/2$ , $X+\lambda/2$ ) varying in opposite directions from one structure (S1) to the other (S2) with respect to the longitudinal axis of symmetry (Y) of the assembly and on proceeding away from the latter.

15. Filter according to any one of Claims 1 to 13, characterized in that the number of electrodes of the central reflector (81, 82) is chosen so that the reflection coefficient is substantially equal to -3 dB.

16. Filter according to Claim 15, characterized in that the central reflector (81, 82) is furthermore weighted by electrode suppression and that it includes neutral cells which replace the suppressed electrodes so as to maintain a constant metallization ratio.

17. Surface wave filter according to any one of Claims 1 to 16, characterized in that it is placed on a single substrate (1) and in that the said channels (V1, V2, ...) are offset longitudinally with respect to one another so as to cancel, by placing in phase opposition, the couplings between these channels.

18. Filter according to any one of Claims 1 to 17, characterized in that it comprises no processing against the bulk waves of the substrate on which the members of the filter are installed.

**Patentansprüche**

1. Filter mit akustischen Oberflächenwellen und Resonanzhohlräumen ($6_1$, $8_1$; $7_1$; $6_2$, $8_2$; $8_2$, $7_2$) in Längsrichtung, wobei das Filter N parallele Filterkanäle (V1, V2, ...) besitzt und N eine ganze Zahl mindestens gleich 2 ist, und wobei jeder Kanal einen Eingangstransduktor ($2_1$, $2_2$, ...) und einen Ausgangstransduktor ($4_1$, $4_2$, ...) aufweist, die zwischen sich eine direkte Strecke definieren, und mindestens zwei reflektierende Netze ($6_1$; $7_1$) enthält, die für diesen Kanal mindestens einen Resonanzhohlraum in Längsrichtung definieren, wobei die Durchlaßamplituden zumindest für diese direkten Strecken praktisch die gleichen für diese N Kanäle sind, dadurch gekennzeichnet,

- N eine gerade Zahl größer oder gleich zwei ist,
- daß der Unterschied in der Ausbreitungslänge auf der direkten Strecke für zwei aufeinanderfolgende Kanäle (V1, V2) im wesentlichen, abgesehen von einem ganzzahligen Vielfachen der Wellenlänge ($\lambda$) bei der zentralen Filterfrequenz (fo), dem N-ten Teil dieser Wellenlänge ($\lambda$) gleicht, so daß für diese zentrale Frequenz (fo) die Vektorresultierende der Signale dieser N Kanäle, die den direkten Strecken entsprechen, praktisch Null ist,

- und daß jeder Kanal einen zentralen Reflektor ($8_1$, $8_2$) besitzt,

und daß somit praktisch die Transferfunktion als Verzögerungsleitung außerhalb des Sperrbands des Filters zu Null wird.

2. Filter mit akustischen Oberflächenwellen und Resonanzhohlräumen ($6_1$, $8_1$; $7_1$; $6_2$, $8_2$; $8_2$, $7_2$) in Längsrichtung, wobei das Filter N parallele Filterkanäle (V1, V2, ...) besitzt und N eine ganze Zahl mindestens gleich 2 ist, und wobei jeder Kanal einen Eingangstransduktor ($2_1$, $2_2$, ...) und einen Ausgangstransduktor ($4_1$, $4_2$, ...) aufweist, die zwischen sich eine direkte Strecke definieren, und mindestens zwei reflektierende Netze ($6_1$; $7_1$) enthält, die für diesen Kanal mindestens einen Resonanzhohlraum in Längsrichtung definieren, wobei die Durchlaßamplituden zumindest für diese direkten Strecken praktisch die gleichen für diese N Kanäle sind, dadurch gekennzeichnet,

- daß N eine ungerade Zahl größer oder gleich drei ist,
- daß der Unterschied in der Ausbreitungslänge auf der direkten Strecke für zwei aufeinanderfolgende Kanäle (V1, V2) im wesentlichen, abgesehen von einem ganzzahligen Vielfachen der Wellenlänge ($\lambda$) bei der zentralen Filterfrequenz (fo), dem N-ten Teil dieser Wellenlänge ($\lambda$) gleicht, so daß für diese zentrale Frequenz (fo) die Vektorresultierende der Signale dieser N Kanäle, die den direkten Strecken entsprechen, praktisch Null ist,

und daß somit praktisch die Transferfunktion als Verzögerungsleitung außerhalb des Sperrbands des Filters zu Null wird.

3. Filter nach Anspruch 1 oder 2, dadurch gekennzeichnet, daß jede Gruppe aus einem Transduktor und einem Reflektor netz eine gemeinsame Vorrichtung vom Typ DART ($62_1$-$47_2$) bildet.

4. Filter nach einem der Ansprüche 1 bis 3, dadurch gekennzeichnet, daß die Reflexionskoeffizienten der DART-Vorrichtungen ($62_1$-$47_2$) im Kurzschluß gleich sind.

5. Filter nach einem beliebigen der Ansprüche 3 und 4, dadurch gekennzeichnet, daß mindestens eine der DART-Vorrichtungen ($62_1$-$47_2$) durch Unterdrückung von Quellen gewichtet ist.

6. Filter nach einem beliebigen der Ansprüche 3 und 4, dadurch gekennzeichnet, daß mindestens eine der DART-Vorrichtungen ($62_1$-$47_2$) durch eine variable Überdeckung der Finger gewichtet ist.

7. Filter nach einem beliebigen der Ansprüche 3 bis 6, dadurch gekennzeichnet, daß mindestens eine der DART-Vorrichtungen ($62_1$-$47_2$) vom EWC-Typ mit einer Verschiebung von $\lambda/48$ ist.

8. Filter nach einem beliebigen der Ansprüche 3 bis 6, dadurch gekennzeichnet, daß mindestens eine der DART-Vorrichtungen ($62_1$-$47_2$) vom EWC-Typ mit einer Verschiebung von $-\lambda/16$ ist.

9. Filter nach einem beliebigen der Ansprüche 3 bis 6, dadurch gekennzeichnet, daß mindestens eine der DART-Vorrichtungen ($62_1$-$47_2$) aus einer Gruppe von abwechselnden Sendezellen und Reflektorzellen gebildet wird, wobei jede Sendezelle drei Elektroden einer Breite $\lambda/6$ besitzt, die einen Abstand von $3\lambda/4$ über eine Strecke gleich $\lambda$ mit zwei inaktiven Elektroden gefolgt von einer aktiven Elektrode aufweisen, während jede Reflektorzelle zwei inaktive Elektroden der Breite $\lambda/4$ in einem Abstand von $3\lambda/8$ über eine Strecke gleich $\lambda$ besitzt.

10. Oberflächenwellenfilter nach einem beliebigen der Ansprüche 1 bis 9, dadurch gekennzeichnet, daß es auf einem gemeinsamen Substrat (1) ausgebildet ist und daß eine Längsrinne (9) in dieses Substrat zwischen jeweils zwei benachbarte Kanäle (V1, V2, ...) eingeschnitten ist, um sie gegenseitig für die akustischen Oberflächenwellen zu isolieren.

11. Oberflächenwellenfilter nach einem beliebigen der Ansprüche 1 bis 9, dadurch gekennzeichnet, daß es auf einem gemeinsamen Substrat (1) ausgebildet ist und daß eine Längsschicht (10) aus einem die akustischen Oberflächenwellen absorbierenden Material zwischen je zwei Kanäle (V1, V2, ...) aufgebracht ist.

12. Oberflächenwellenfilter nach einem beliebigen der Ansprüche 1 bis 11, dadurch gekennzeichnet, daß jeder dieser Kanäle (V1, V2, ...) bezüglich der Mittellinie (L) des Raums zwischen den Transduktoren symmetrisch ist.

13. Oberflächenwellenfilter nach Anspruch 1, dadurch gekennzeichnet, daß jeder der Kanäle einen zentralen Reflektor (8) und zwei äußere Reflektoren (6, 7) enthält.

14. Oberflächenwellenfilter nach einem der Ansprüche 1 bis 13, dadurch gekennzeichnet, daß für eine zusätzliche Sperrung auf der direkten Strecke für die Frequenzen, die im Sperrband von der zentralen Frequenz (fo) abweichen, das Filter aus der parallelen Anordnung von zwei solchen oben erwähnten Strukturen (S1, S2) mit mehreren Kanälen gebildet wird, wobei diese Strukturen vom gleichen Typ sind, aber Verschiebungen der direkten Strecken ($x-\lambda/2$, $x+\lambda/2$) besitzen, die in umgekehrter Richtung von einer Struktur (S1) zur anderen (S2) bezüglich der Längssymmetrieachse (Y) der Einheit und mit zunehmender Entfernung von dieser Symmetrieachse variieren.

15. Filter nach einem beliebigen der Ansprüche 1 bis 13, dadurch gekennzeichnet, daß die Anzahl von Elektroden des zentralen Reflektors ($8_1$, $8_2$) so gewählt ist, daß der Reflexionskoeffizient im wesentlichen den Wert -3dB besitzt.

16. Filter nach Anspruch 15, dadurch gekennzeichnet, daß der zentrale Reflektor ($8_1$, $8_2$) außerdem durch Unterdrückung von Elektroden gewichtet ist und neutrale Zellen besitzt, die die unterdrückten Elektroden ersetzen, um einen konstanten Metallisierungsgrad beizubehalten.

17. Oberflächenwellenfilter nach einem beliebigen der Ansprüche 1 bis 16, dadurch gekennzeichnet, daß es auf einem gemeinsamen Substrat (1) ausgebildet ist und daß die Kanäle (V1, V2, ...) in Längsrichtung gegeneinander so versetzt sind, daß die Kopplungen zwischen diesen Kanälen durch die Gegenphasigkeit zu Null werden.

18. Filter nach einem beliebigen der Ansprüche 1 bis 17, dadurch gekennzeichnet, daß es keine besondere Maßnahmen gegen die Volumenwellen des Substrats gibt, auf dem die Organe des Filters ausgebildet sind.

Fig.1

Fig.2

**Fig.3**

**Fig.4**

**Fig.5**

**Fig.6**

**Fig.7**

$$X - \frac{\lambda}{2}$$

$$x$$

$$S_1$$

$$S_2$$

$$X + \frac{\lambda}{2}$$

**Fig.8**

**Fig.9**

$$S_1$$

$$S_2$$

**Fig.10**

$$S_1$$

$$S_2$$

**Fig.11**

$$S_1$$

$$S_2$$

**Fig.12**

$$S_1$$

$$S_2$$

$e_1$    $e_1$    $e_2$    $e_2$

groupe i      groupe i+1

# Fig.13

$62_1$   X   $8_1$   X   $47_1$

| DART | $\boxtimes$ | DART |

Entrée o            o Sortie

| DART | $\boxtimes$ | DART |

$62_2$   $X+\dfrac{\lambda}{4}$   $8_2$   $X+\dfrac{\lambda}{4}$   $47_2$

# Fig.14

$\lambda/4$    $\lambda/6$    $3\lambda/4$    $\lambda/4$    $\lambda/8$

R'        T    R    R

[+]   [−]   [−]   [+]   [−]   [−]

$\dfrac{3\lambda}{8}$

Ref         Ref

$\lambda$

# Fig.15

# Fig.16

# Fig.17

# Fig.18